(19) Europäisches Patentamt
European Patent Office
Office européen des brevets

(11) **EP 3 226 309 B1**

(12) **EUROPEAN PATENT SPECIFICATION**

(45) Date of publication and mention
of the grant of the patent:
**01.12.2021 Bulletin 2021/48**

(51) Int Cl.:
*H01L 31/112* *(2006.01)*          *H01L 31/0232* *(2014.01)*
*H01L 31/028* *(2006.01)*          *H01L 31/0352* *(2006.01)*
*H01L 27/146* *(2006.01)*          *G01T 1/20* *(2006.01)*

(21) Application number: **16163539.6**

(22) Date of filing: **01.04.2016**

(54) **APPARATUS FOR PHOTODETECTION AND MANUFACTURING METHOD THEREOF**

VORRICHTUNG ZUR FOTODETEKTION UND DESSEN HERSTELLUNGSVERFAHREN

DISPOSITIF DE PHOTODÉTECTION ET PROCÉDÉ POUR SA FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.10.2017 Bulletin 2017/40**

(73) Proprietor: **Nokia Technologies Oy
02610 Espoo (FI)**

(72) Inventor: **Allen, Mark
Cambridge, Cambridgeshire CB23 6BA (GB)**

(74) Representative: **Swindell & Pearson Limited
48 Friar Gate
Derby DE1 1GY (GB)**

(56) References cited:
**JP-A- 2003 185 751          JP-A- 2013 190 310
US-A1- 2004 180 462          US-A1- 2005 178 971
US-A1- 2006 091 289          US-A1- 2006 244 907
US-A1- 2013 032 782          US-A1- 2014 263 945**

- **ROUHI NIMA ET AL: "Ultrahigh conductivity of large area suspended few layer graphene films", APPLIED PHYSICS LETTERS, A I P PUBLISHING LLC, US, vol. 101, no. 26, 263101, 26 December 2012 (2012-12-26), pages 1-3, XP012168611, ISSN: 0003-6951, DOI: 10.1063/1.4772797 [retrieved on 2012-12-26]**
- **AVERY J GREEN ET AL: "Thickness and Rotational Effects in Simulated HRTEM Images of Graphene on Hexagonal Boron Nitride", MICROSCOPY AND MICROANALYSIS, vol. 20, no. 6, 1 December 2014 (2014-12-01), pages 1753-1763, XP001592995, ISSN: 1431-9276, DOI: 10.1017/S1431927614013105 [retrieved on 2014-09-15]**
- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNOLOGICAL FIELD

Examples of the disclosure relate to an apparatus and method of forming an apparatus for photo-detection. In particular examples of the disclosure relate to an apparatus and method of forming an apparatus for photo-detection comprising graphene.

BACKGROUND

Apparatus comprising photodetectors have a wide range of uses. For instance they can be used in cameras, in infrared detectors, in x-ray detectors and in other suitable devices.

It is useful to provide an apparatus comprising photodetectors which provides an improved array of photodetectors for such apparatus. This may provide improved images and/or may provide a more versatile device.

US 2006/0244907 teaches the use of channel mapped optics (CMO) in optical devices. The CMOs control light in a non-refractive manner to achieve visual effects that are not practical with refractive or reflective optics. US 2006/0244907 teaches a CMO matrix where the channels in the matrix are angled to enable light to be captured from a single point. The channels are arranged at a random or pre-planned set of angles.

US 2014/263945 teaches a floating-gate transistor photodetector. D2 teaches that graphene is one of a number of materials that could be used as a material for the channel in the transistor.

BRIEF SUMMARY

The invention refers to an apparatus as defined by the subject-matter of claim 1, and to a method of manufacturing such an apparatus as defined by the subject-matter of claim 15. The substrate may be arranged to absorb photons so that photons incident on an inner wall of an aperture are absorbed.

The graphene overlaying the second end of the aperture may be arranged as a channel within a field effect transistor. Contact electrodes of the field effect transistor may be formed on the substrate adjacent to the second end of the aperture.

The substrate may be flexible.

In an exaample not part of the invention substrate may be curved. The at least one aperture may be filled.

The at least one aperture may be non-filled. The apparatus may comprise a support layer arranged to support the graphene over the second end of the aperture. The support layer may comprise hexagonal boron nitride.

The diameter of the aperture may be smaller than the length of the aperture.

The apparatus may comprise a scintillator overlaying the substrate and arranged to convert incident x-rays into visible photons.

According to various, but not necessarily all, examples of the disclosure there may be provided an x-ray detector comprising an apparatus as claimed in any preceding claim.

According to various, but not necessarily all, examples of the disclosure there may be provided a camera comprising an apparatus as claimed in any of claims 1 to 14. The substrate may be arranged to absorb photons so that photons incident on an inner wall of an aperture are absorbed.

The method may comprise arranging the graphene overlaying the second end of the aperture as a channel within a field effect transistor. The method may comprise forming contact electrodes of the field effect transistor on the substrate adjacent to the second end of the aperture.

The substrate may be flexible.

In an example not part of the invention substrate may be curved.

The at least one aperture may be filled.

The at least one aperture may be non-filled. The method may comprise providing a support layer arranged to support the graphene over the second end of the aperture. The support layer may comprise hexagonal boron nitride.

The diameter of the aperture may be smaller than the length of the aperture.

The method may comprise providing a scintillator overlaying the substrate and arranged to convert incident x-rays into visible photons.

According to various, but not necessarily all, examples of the disclosure, there are provided examples as claimed in the appended claims.

BRIEF DESCRIPTION

For a better understanding of various examples that are useful for understanding the detailed description, reference will now be made by way of example only to the accompanying drawings in which:

Fig. 1 illustrates an apparatus:
Figs. 2A to 2D illustrate an apparatus;
Figs. 3A to 3B illustrate an apparatus;
Fig. 4 illustrates an apparatus in use as a camera;
Fig. 5 illustrates an apparatus with a curved substrate;
Fig. 6 illustrates an apparatus in use as an x-ray detector;
Fig. 7 illustrates another apparatus with a curved substrate;
Fig. 8 illustrates an example x-ray detector in use with a curved substrate;
Fig. 9 is a geometric representation of the field of view for each photodetector pixel within an apparatus;
Fig. 10 is a geometric representation of the field of view for each photodetector pixel within an apparatus with a curved substrate;
Figs. 11A and 11B illustrate an example apparatus with a curved substrate; and
Fig. 12 illustrates an example method.

## DETAILED DESCRIPTION

The Figures illustrate an apparatus 1 comprising: a substrate 3 comprising at least one aperture 5 extending through the substrate 3 wherein the aperture 5 has a first end 7 and a second end 9 and wherein the substrate 3 is arranged such that one or more photons 17 incident on the first end 7 of the aperture 5 pass through the aperture 5 to the second end 9; and a photodetector 11 positioned overlaying the second end 9 of the aperture 5 wherein the photodetector 11 comprises graphene 13 functionalised with quantum dots 15.

The apparatus 1 may be for detecting photons. A plurality of photodetectors 11 may be arranged in an array on the substrate 3 to enable an image to be obtained. The apertures 5 within the substrate 3 may be arranged so that the images that are obtained by the array of photodetectors 11 are in focus. The apparatus 1 may be used in a lensless camera, an x-ray detector, an infrared detector or any other suitable device.

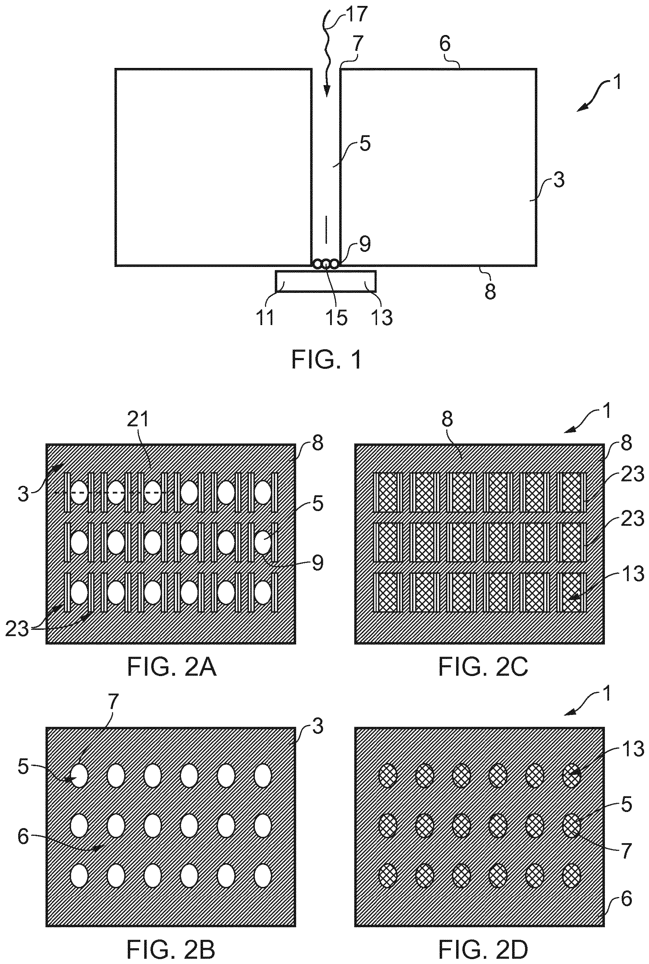

Fig. 1 schematically illustrates an apparatus 1 according to an example of the disclosure. The apparatus 1 comprises a substrate 3 and a photodetector 11.

The substrate 3 comprises a support layer upon which one or more photodetectors can be provided. In the example of Fig. 1 the substrate 3 is arranged in a flat configuration, in other examples the substrate 3 could be curved. In some examples the substrate 3 may be flexible so that the curvature of the substrate 3 may be controlled by a user of the apparatus 1. In such examples the material and/or the thickness of the substrate 3 may be selected to ensure that a user can bend and/or flex and/or otherwise deform the substrate 3.

The substrate 3 may be formed from an insulating material so that photodetectors 11 and/or other electronic components can be provided on the substrate 3. In some examples the substrate 3 may be formed from a material such as silicon, polymer or any other suitable material. In some examples the substrate 3 may comprise a thin film metal substrate 3 or any other suitable material.

The substrate 3 has a first surface 6 and a second surface 8. The surfaces 6, 8 are provided on opposite sides of the substrate 3. The surfaces 6, 8 may provide surfaces upon which electronic components may be provided. The electronic components may be formed on the surfaces 6, 8. For instance electrical contacts and conductive traces could be printed onto the surfaces 6, 8 as needed. In the example of Fig. 1 the photodetector 11 is provided on the second face 8.

In examples of the disclosure the substrate 3 comprises at least one aperture 5. The aperture 5 comprises a thru hole which extends all the way through the thickness of the substrate 3. The aperture 5 has a first end 7 which is provided on the first surface 6 of the substrate 3 and a second end 9 which is provided on the second surface 8 of the substrate 3.

The aperture 5 may be formed within the substrate 3 using any suitable process. The aperture 5 may be formed using a laser drill or any suitable means.

The length of the aperture 5 is the distance between the first end 7 and the second end 9. In the example of Fig. 1 the length of the aperture 5 corresponds to the thickness of the substrate 3.

In examples of the disclosure the length of the aperture 5 may be greater than the diameter of the aperture 5. The length of the aperture 5 may be multiple times larger than the diameter of the aperture 5 so that an elongate aperture 5 is provided.

The aperture 5 may be any suitable size. In some examples the aperture 5 may have a diameter of around 50 micrometers. The size of the aperture 5 may be determined by the process that is used to form the aperture 5.

The aperture 5 within the substrate 3 is arranged so that only photons 17 arriving from a particular direction pass through the aperture 5 from the first end 7 to second end 9. The aperture 5 within the substrate 3 is arranged so that only photons 17 aligned with the length of the aperture 5 pass through the aperture from the first end 7 to the second end 9. The aperture 5 is arranged so that photons 17 that are aligned with the length of the aperture 5 pass through the aperture 5 without being incident on a side wall of the aperture 5.

The aperture 5 may be arranged so that photons 17 that are not aligned with the length of the aperture 5 are absorbed before they reach the second end 9 of the aperture 5. The photons 17 that are not aligned with the length of aperture 5 are incident on an inner wall of the aperture 5. The substrate 3 may comprise a material which is arranged to absorb the photons 17 that are incident on the inner wall of the aperture 5. In some examples a coating may be provided on the inner wall of the aperture 5 which may be arranged to absorb the incident photons 17.

The apparatus 1 also comprises a photodetector 11 comprising graphene 13 functionalised with quantum dots 15.

The graphene 13 may be provided between source and drain electrodes. The graphene 13 may be provided as a channel in a field effect transistor. The graphene 13 may be provided in a thin layer. In some examples the graphene 13 may have a thickness in the range of nanometers. In some examples the graphene 13 may comprise an atomic monolayer.

In the example apparatus 1 of Fig. 1 quantum dots 15 are coupled to the graphene 13. In the example of Fig. 1 the quantum dots 15 are provided overlaying the graphene 13. In other examples the quantum dots 15 may be provided within and/or adjacent to the graphene channel 13.

The quantum dots 15 may comprise a nanocrystal in which there is quantum confinement in all three dimensions. The quantum dots 15 may comprise any suitable material. The material that is used for the quantum dots 15 may be chosen to enable photons 17 to be detected. In some examples the quantum dots 15 may comprise lead sulphide, cadmium sulphide, cadmium selenide, or any other suitable material.

The quantum dots 15 are arranged so that photons 17 which pass through the length of the aperture 5 are incident on the quantum dots 15. The quantum dots 15 may be provided on one side of the graphene 13. In the example of Fig. 1 the quantum dots 15 are provide on the side of the graphene 13 which faces the substrate 3. In other examples the quantum dots 15 could be provided on the side of the graphene 13 which faces away from the substrate 3.

The quantum dots 15 convert incident photons 17 into electrical charge. The changes in charge distribution caused by the incident photons 17 may be detected by the graphene 13 which produces a measurable electronic response. The electronic response provides an indication of photons 17 which pass through the aperture 5. This enables the apparatus 5 to be arranged to detect photons 17 which are aligned with the aperture 5. An array of apertures 5 and photodetectors 11 may be arranged to obtain an image. As only photons 17 that are aligned with the apertures 5 are detected the image is in focus.

Figs. 2A to 2D illustrate an example apparatus 1 which comprises a plurality of apertures 5. A photodetector 11 is positioned overlaying each of the apertures 5.

Fig. 2A illustrates a second surface 8 of a substrate 3 before the graphene 13 is provided. The substrate 3 comprises a plurality of apertures 5 arranged in an array 21. The apertures 5 may extend through the substrate 3 as described in relation to Fig. 1. The second ends 9 of the apertures 5 are provided in the second surface 8 of the substrate 3.

In the example of Fig. 2A the array 21 comprises eighteen apertures 5 arranged in a plurality of perpendicular rows and columns. It is to be appreciated that any number of apertures 5 may be provided in other examples of the disclosure. The plurality of apertures 5 may be arranged in any suitable arrangement in other examples of the disclosure.

In the example of Fig. 2A each of the apertures 5 has a circular cross section. The shape of the apertures 5 may be determined by the process that is used to form the aperture 5. It is to be appreciated that other shapes may be used in other examples of the disclosure.

In the example of Fig. 2A a pair of contact electrodes 23 are provided adjacent to each of the apertures 5. The contact electrodes 23 may be arranged to provide a source and drain electrode for a field effect transistor.

The contact electrodes 23 may be made of any suitable material such as gold, silver, nickel, aluminium, copper or any other conductive material including alloys such as aluminium-copper (Al-Cu). The contact electrodes 23 may be formed directly onto the second surface 8 of the substrate 3. In some examples the contact electrodes 23 may be printed onto the second surface 8 of the substrate 3.

In some examples other circuitry may also be provided on the second surface 8 of the substrate 3. The other circuitry may comprise read-out circuitry, data processing circuitry or any other suitable circuitry.

Fig. 2B illustrates the first surface 6 of the substrate 3 before the graphene 13 is provided. The substrate 3 comprises the array 21 of apertures 5 as illustrated in Fig. 2A. The first ends 7 of the apertures 5 are provided in the first side 6 of the substrate 8.

Fig. 2C illustrates the second surface 8 of a substrate 3 after the graphene 13 is provided. The graphene 13 may be formed by any suitable method and transferred to the second surface 8 of the substrate 3.

The graphene 13 is provided overlaying the contact electrodes 23 so that each of the pairs of contact electrodes 23 and the layers of graphene 13 form a field effect transistor. Each of the field effect transistors forms a photodetector 11 so that the apparatus 1 comprises a plurality of photodetectors 11.

The graphene 13 is provided overlaying the second end 9 of the aperture 5. The graphene 13 may be provided overlaying the second end 9 of the aperture 5 so that the graphene 13 is suspended over the aperture 5. In some examples a support layer may be provided to support the graphene 13 over the aperture 5.

In the example of Fig. 2C the graphene 13 completely covers the second end 9 of the aperture 5 so that any photons 17 that pass through the aperture 5 are incident on the graphene 13. The aperture 5 may be arranged as described in relation to Fig. 1 so that only photons 17 that are aligned with the length of the aperture 5 are incident on the graphene 13.

The graphene 13 is functionalised with quantum dots 15, which may be as described above, so that photons 17 that pass through the aperture 5 are converted into an electrical charge.

Fig. 2D illustrates the first surface 6 of the substrate 3 after the graphene 13 is positioned overlaying the contact electrodes 23. The graphene 13 can be seen through the apertures 5.

Each of the photodetectors 11 in the apparatus 1 acts as a pixel. This may enable an image to be formed from the signals provided by each of the photodetectors 11 in response to incident photons 17. As only photons 17 that are aligned with the aperture 5 are incident on the photodetector 11 this ensures that the image obtained by the array of photodetectors 11 is in focus.

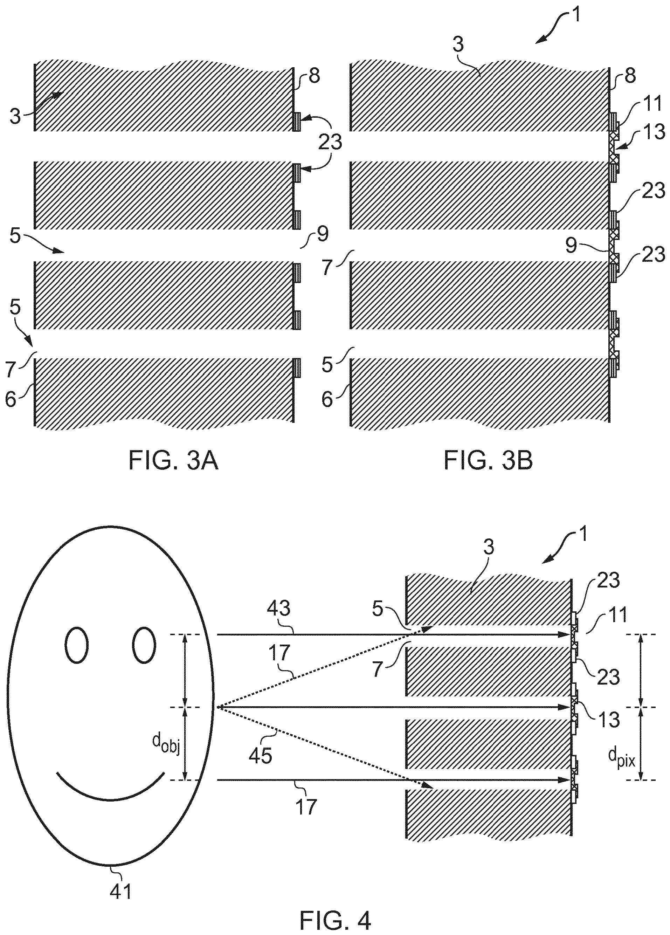

Figs. 3A and 3B illustrate a cross section of an example apparatus 1. Apparatus 1 could be a section of the apparatus 1 as illustrated in Figs. 2A to 2D.

Fig. 3A illustrates a cross section of a substrate 3 before the graphene 13 is provided. The substrate 3 comprises a plurality of apertures 5 which extend from the first surface 6 of the substrate 3 to the second surface 8.

In the example of Fig. 3A the substrate 3 is flat and each of the apertures 5 are parallel to each other. The apertures 5 are parallel to each other such that each of the lengths of the apertures 5 extend parallel to the lengths of the other apertures 5. The apertures 5 extend perpendicular to the plane of the second surface 8. Once the photodetectors 11 are formed the apertures 5 extend perpendicular to the plane of the photodetectors 11.

In the example of Fig. 3A a pair of contact electrodes 23 are provided on the second surface 8 of substrate 3 adjacent to each of the apertures 5. The contact electrodes 23 may be arranged to provide a source and drain electrode for a field effect transistor as described above.

Fig. 3B illustrates a cross section of the substrate 3 after the graphene 13 is provided. The graphene 13 is provided overlaying the contact electrodes 23 so that each of the pairs of contact electrodes 23 and the layers of graphene 13 form a field effect transistor which may be as described above.

The graphene 13 is functionalised with quantum dots 15 so that photons 17 that pass through the aperture 5 are converted into an electrical charge. The quantum dots 15 may be patterned on to the graphene 13 after the graphene 13 has been transferred to the substrate 3.

The quantum dots 15 may be provided on either side of the graphene 13. In some examples the quantum dots 15 may be provided on the side of the graphene 13 which faces towards the substrate 3. In other examples the quantum dots 15 may be provided on the side of the graphene 13 which faces away from the substrate 3.

If the quantum dots 15 are provided on the side of the graphene 13 which faces towards the substrate 3 the quantum dots 15 may be patterned through onto the graphene 13 through the apertures 5. This may ensure that the quantum dots 15 are provided in the areas where photons 17 can be detected.

In the examples of Figs 2A to 3B the graphene 13 and contact electrodes 23 are formed on the substrate 3 around the apertures 5. This ensures that the photodetectors 11 are aligned with the apertures 5. This method of forming the photodetectors 11 may enable alignment of the photodetectors 11 and the apertures 5 even when the apertures are very small. This may also enable a small separation between the photodetectors 11. This may allow for a small pixel pitch for the array of photodetectors 11. Using a small pixel pitch may increase the resolution of images obtained using the apparatus 1.

In the example of Figs. 2A to 3B the graphene 13 is suspended over the second end 9 of the aperture 5. The apertures 5 are unfilled so that there is nothing within the aperture 5 which supports the graphene 13. In some examples the apparatus 1 may comprise a support layer to support the graphene 13. In some examples the support layer could be provided on the second surface 8 of the substrate 3 between the substrate 3 and the graphene 13. In such examples the support layer is transparent to enable photons 17 to pass through the support layer to the graphene 13. In some examples the support layer may comprise hexagonal boron nitride. Hexagonal boron nitride may be suitable for use as a support layer as it has a structure very similar to the structure of graphene 13. This may reduce any defects introduced into the graphene 13 by the support layer.

In some examples the support layer may be provided on the outer side of the graphene 13 so that the graphene 13 is sandwiched between the substrate 3 and the support layer. In such examples the support layer does not need to be transparent. In some examples the support layer may be opaque to prevent photons 17 passing through the support layer onto the graphene 13. This may ensure that only photons 17 that have passed through the apertures 5 are detected by the photodetectors 11. In some examples the support layer may form part of the encapsulation of the apparatus 1.

In some examples the apertures 5 may be filled or at least partially filled. The apertures 5 may be filled with a material which is transparent to photons 17. The material that is used to fill the apertures may also support the graphene 13 overlaying the second end 9 of the aperture 5. This optically transparent material may also form part of the encapsulation of the apparatus 1.

In the example of Figs. 2A to 3B the photodetectors 11 comprise two contact electrodes 23 formed on the second surface 8 of the substrate 3. In other examples other arrangements of electrodes may be used.

Fig. 4 illustrates an apparatus 1 in use as camera. The camera may be a lensless camera as the substrate 3 and apertures 5 focus the image obtained by the camera by filtering photons which are not aligned with the apertures 5.

In the example of Fig. 4 the apparatus 1 comprises a flat substrate 3 with a plurality of apertures 5 and photodetectors 11 which may be as described above. In the example of Fig. 4 only three apertures 5 and photodetectors 11 are illustrated. It is to be appreciated that in other examples other numbers of apertures 5 and photodetectors 11 may be used.

The object 41 which is to be imaged is positioned in front of the apparatus 1. Photons 17 from the object 41 are directed in different directions. Photons 17 that are aligned with the apertures 5 are indicated by solid lines 43 and photons 17 that are not aligned with the apertures 5 are indicated by dotted lines 45. It is to be appreciated that photons 17 directed in a particular direction may also be referred to as light rays directed in a particular direction.

As indicated by the dotted lines 45 photons 17 that are not aligned with the apertures 5 are incident on the substrate 3. The photons 17 are incident on the inner walls of the substrate 3. The substrate 3 may be made of a material which absorbs the photons 17 so that these photons 17 are absorbed and prevented from passing through the aperture 5 to the photodetector 11. In some examples a coating may be provided on the inner walls of the apertures 5 to absorb the photons 17 that are not aligned with the aperture 5. The coating may comprise a matt black material such as a carbon coating or any other suitable material.

In some examples the inner walls of the aperture 5 may have a rough surface so that any photons 17 incident on the inner walls are redirected. This may attenuate the photons 17 before they are incident on the photodetector 11 and/or may reflect the photons 17 back out of the aperture 5.

Photons 17 which are aligned with the apertures 5 pass through the apertures 5 and are incident on the photodetector 11. This enables a focussed image of the object 41 to be obtained by the array of photodetectors 11.

The diameter of the aperture 5 and the thickness of the substrate 3 affects the number of photons 17 that are absorbed before they are incident on the photodetector 11. The longer the length of the aperture 5 the fewer photons 17 will be adequately aligned with the length of the aperture 5 so that they will be detected by the photodetector 13. Similarly the narrower the diameter of the aperture 5 the fewer photons 17 will be adequately aligned with the length of the aperture 5. The thickness of the substrate 3 and/or the diameter of the apertures 5 may be selected so as to provide a desired level of sensitivity for the apparatus 1.

In the example of Fig. 4 the substrate 3 is flat and the apertures 5 are perpendicular to the array of photodetectors 11. The resolution $d_{obj}$ of an image of an object obtained by the apparatus is equal to the pixel pitch $d_{pix}$:

$$d_{obj} = d_{pix}.$$

This may enable a lower pixel pitch to be used to achieve the same level of resolution than would be used in a camera which uses lenses to focus the image. This may be useful if the apparatus 1 is formed on a large area substrate 3.

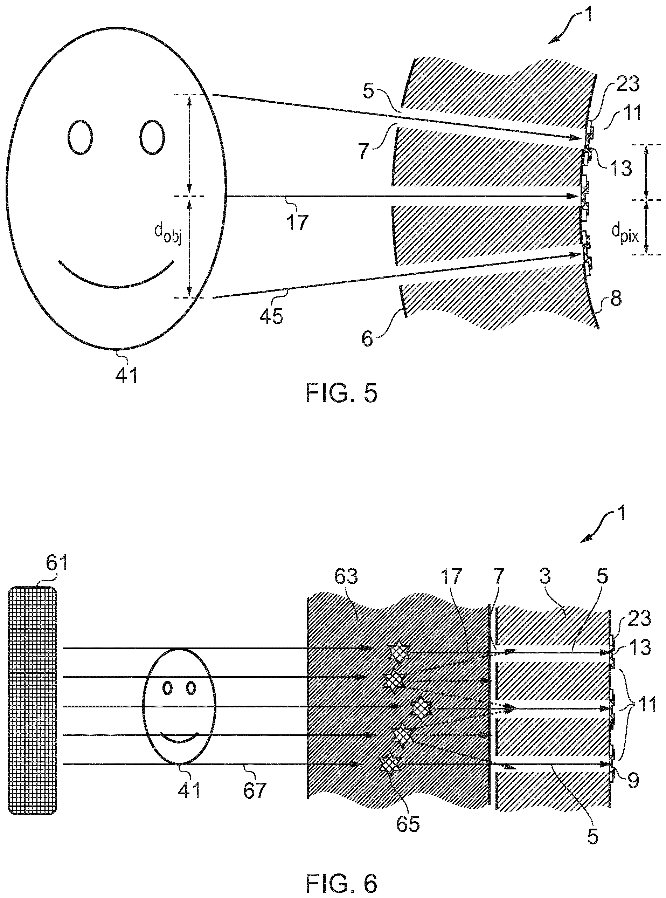

Fig. 5 illustrates another apparatus 1 in use as a lensless camera. In the example of Fig. 5 the apparatus 1 comprises a curved substrate 3.

In the example of Fig. 5 the substrate 3 is curved so that the first surface 6 of the substrate 3 is convex and the second surface 8 of the substrate 3 is concave. The photodetectors 11 are provided on the concave second surface 8.

In some examples the substrate 3 may comprise a rigid substrate that has a fixed radius of curvature. This may enable the radius of curvature of the substrate 3 to be optimised for imaging a particular type of objects 41.

In some examples the substrate 3 may comprise a flexible substrate 3 which may be arranged to enable a user to adjust the radius of curvature of the substrate 3. This may enable the apparatus 1 to be adjusted for use with different objects 41. The substrate 3 may be arranged to enable a user to bend the substrate to obtain the desired field of view for the apparatus 1.

In the example of Fig. 5 the curvature of the substrate 3 increase the field of view compared to the flat substrate 3 used in the example of Fig. 4. The resolution $d_{obj}$ of an image of an object obtained by the apparatus is greater than the pixel pitch $d_{pix}$:

$$d_{obj} > d_{pix}$$

Fig. 6 illustrates another apparatus 1 in use as an x-ray detector. The x-ray detector may be used for medical imaging, security purposes or any other suitable applications.

In the example of Fig. 6 an x-ray source 61 is provided. The x-ray source 61 may comprise any suitable means for providing x-rays 67.

An object 41 that is to be imaged is positioned between the x-ray source 61 and the apparatus 1. The object 41 is positioned between the x-ray source 61 and the apparatus 1 so that x-rays 67 that are not absorbed by the object 41 pass through the object 41 and are incident on the apparatus 1.

The apparatus 1 may be positioned relative to the x-ray source 61 so that the x-rays 67 are parallel or substantially parallel when they are incident on the apparatus 1.

The example apparatus 1 in Fig. 6 comprises a substrate 3 and a plurality of photodetectors 11 which may be as described above. In the example of Fig. 6 the substrate 3 is a flat or substantially flat substrate 3.

In the example of Fig. 6 the apparatus also comprises a scintillator 63. The scintillator 63 may comprise any means which may be arranged to convert 65 incident x-rays 67 into visible photons 17 that can be detected by the photodetectors 11. The scintillator 63 is provided overlaying the substrate 3 so that x-rays 67 incident on the apparatus 1 are incident on the scintillator 63. The photons that are emitted by the scintillator 63 may then be detected by the photodetectors 11 of the apparatus 1.

The x-rays 67 that are incident on the scintillator 63 may be perpendicular to the surface of the scintillator 63. When the x-rays 67 are converted 65 to visible photons 17 the photons 17 may be emitted omnidirectionally. However as only photons 17 that are aligned with the aperture 5 pass through the aperture 5 this means that only the photons 17 in a direction aligned with apertures 5 will be detected by the photodetectors 11.

In some examples the scintillator 63 may be a thick layer. The thick layer may be several millimeters thick. The scattering of photons 17 within the scintillator 63 will normally degrade the resolution of images obtained by such devices. Such thick scintillators typically require a columnar structure to reduce scattering and guide photons 17 towards a photodetector 11. In the example of the disclosure this is not necessary as the apertures 5 in the substrate 3 act to filter out the photons 17 that have been scattered.

As the graphene 13 based photodetectors 11 are very sensitive to incident photons 17 the x-ray imaging device can still obtain high quality images even with the substrate 3 filtering out photons 17 that are not aligned correctly.

In some examples the scintillator 63 may comprise a reflective upper surface. The reflective upper surface may act to reflect photons 17 generated within the scintillator 63 back towards the substrate 3 and the photodetectors 11. This may improve the efficiency of the apparatus 1.

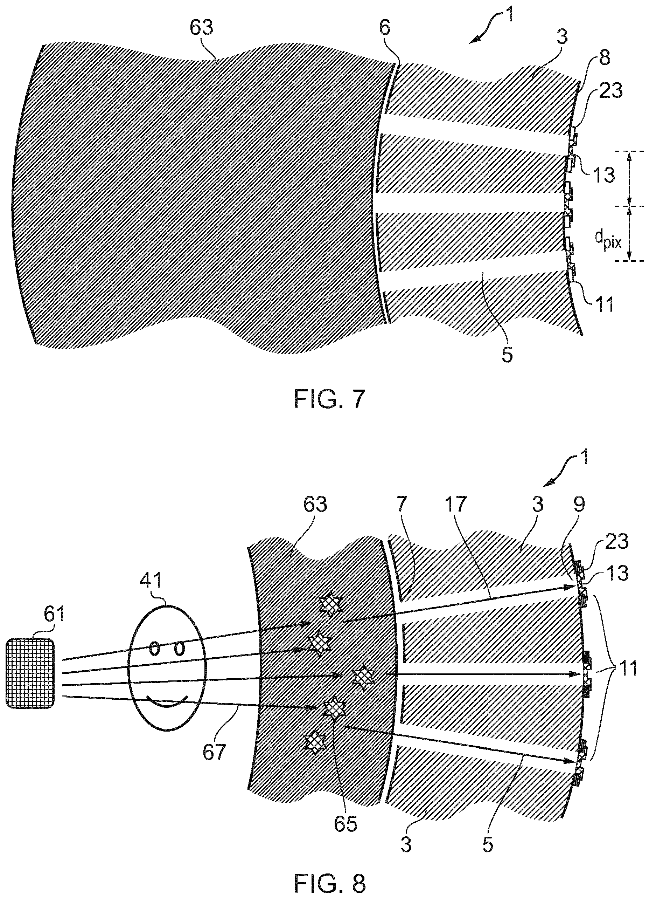

Fig. 7 illustrates another apparatus 1 in use as an x-ray detector. In the example of Fig. 7 the apparatus 1 comprises a curved substrate 3 and a curved scintillator 63.

In the example of Fig. 7 the substrate 3 and the scintillator 63 are curved so that the first surface 6 of the substrate 3 is convex and the second surface 8 of the substrate 3 is concave. The photodetectors 11 are provided on the concave second surface 8.

The scintillator 63 may comprise a flexible material which may enable the scintillator 63 to be flexed and/or deformed with the substrate 3. In other examples the scintillator 63 and substrate 3 could have a fixed radius of curvature.

In the example of Fig. 7 the curvature of the substrate 3 increases the field of view compared to the flat substrate 3 used in the example of Fig. 6. The resolution $d_{obj}$ of an image of an object obtained by the apparatus is greater than the pixel pitch $d_{pix}$:

$$d_{obj} > d_{pix}$$

It is to be appreciated that in other examples the apparatus 1 could be arranged into any suitable shape. Fig. 8 illustrates another example apparatus 1 in which the substrate 3 and the scintillator 63 are curved so that the first surface 6 of the substrate 3 is concave and the second surface 8 of the substrate 3 is convex. In such an arrangement the photodetectors 11 would be provided on the convex second surface 8. This may enable the apparatus to be curved around an object 41. This may enable the apparatus 1 to be used to partially or fully enclose the object being imaged.

Having a flexible apparatus 1 for photo-detection may enable the shape of the apparatus 1 to be adapted to correspond to the shape of the object 41 being imaged. This may improve the efficiency of the imaging device which may reduce the x-ray dosage required. A reduction in the x-ray dosage required is particularly beneficial for medical applications.

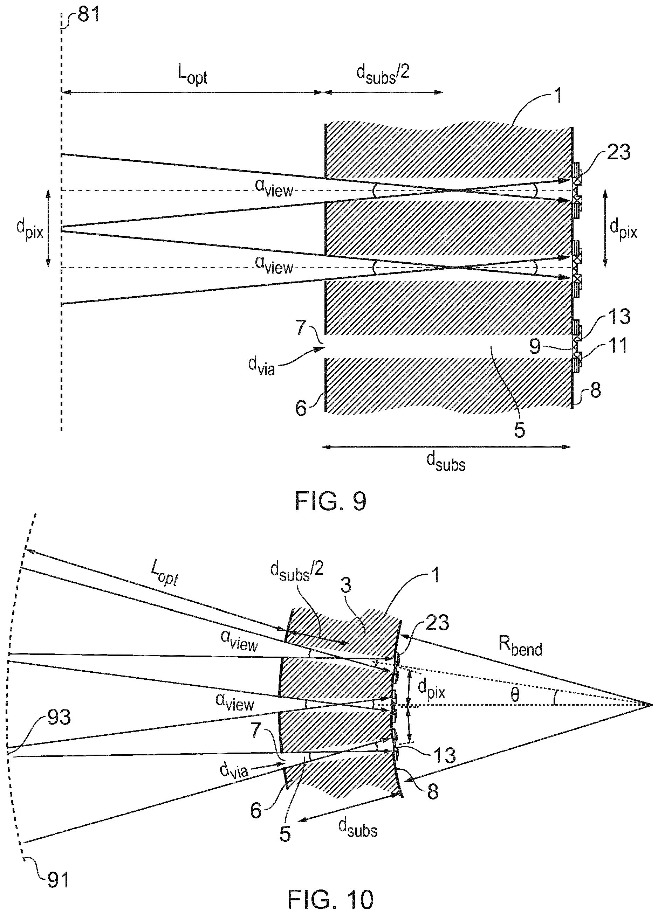

In examples of the disclosure each photodetector 11 provides a pixel within an imaging array. Fig. 9 is a geometric representation of the field of view for each photodetector pixel within an example apparatus 1.

In the example of Fig. 9 the image plane 81 is indicated by the dashed line. The image plane 81 corresponds to the distance $L_{opt}$ from the apparatus 1 at which the paths of photons 17 that are incident on adjacent photodetectors 11 intersect. Any source of scattered omnidirectional photons 17 located beyond $L_{opt}$ could have photons 17 detected by more than one photodetector 11. This reduces the resolution for images positioned beyond $L_{opt}$.

Fig. 9 illustrates the angle of view $\alpha_{view}$ for each photodetector 11. The angle of view $\alpha_{view}$ can be expressed as:

$$\alpha_{view} = 2\arctan\left(\frac{d_{via}}{d_{subs}}\right)$$

Where $d_{via}$ is the diameter of the aperture 5 and $d_{subs}$ is the thickness of the substrate 3. The thickness of the substrate 3 is the same as the length of the aperture 5.

At the image plane 81 the field of view of two adjacent photodetectors 11 overlaps. The distance between the points at which the paths of photons 17 intersect is the same as the pixel pitch $d_{pix}$. This gives:

$$\left(L_{opt} + \frac{d_{subs}}{2}\right) \cdot \tan\left(\frac{\alpha_{view}}{2}\right) = \frac{d_{pix}}{2}$$

hence

$$L_{opt} = \frac{d_{subs}}{2}\left(\frac{d_{pix}}{d_{via}} - 1\right)$$

Therefore the optimal distance between the image plane 81 and the apparatus 1 can be selected by choosing appropriate dimensions for the thickness of the substrate 3 and the diameter of the apertures 5. This may enable the apparatus 1 to be optimized for a particular application.

The distance that is selected for $L_{opt}$ may depend on the application that the apparatus 1 is being used for. For instance, if the apparatus 1 is being used for x-ray imaging a large $L_{opt}$ is not needed because the photons 17 that are detected are emitted from the scintillator 63 which is positioned overlaying the substrate 3.

In such examples typical values for the parameters of the apparatus 1 could be: $d_{pix} = 100\mu$m, $d_{via} = 25\mu$m, $d_{subs} = 300\mu$m. This gives $L_{opt} = 450\mu$m. A different value of $L_{opt}$ could be obtained using different parameter values. For instance if $d_{pix} = 300\mu$m, $d_{via} = 30\mu$m, $d_{subs} = 500\mu$m this gives $L_{opt} = 2250\mu$m. It is to be appreciated that any suitable value for $L_{opt}$ could be obtained by using any suitable parameters for the apparatus 1.

Apparatus 1 having a flat substrate 3 may be suitable for use in near field imaging applications such as x-ray detection. Other near field imaging applications could be medical applications such as vein mapping where an apparatus 1 may be placed in contact with a patient's skin and the area is illuminated with a light source such as one or more light emitting diodes (LEDs).

Fig. 10 is a geometric representation of the field of view for each photodetector pixel within an example apparatus 1 with a curved substrate 3. In the example of Fig. 10 the substrate 3 is curved so that the second surface 8 on which the photodetectors 11 is concave. The substrate 3 has radius of curvature $R_{bend}$.

As the substrate 3 is now curved the image plane 81 is replaced by a curved image surface 91. The curved image surface 91 is indicated by the dashed line in Fig. 10. The curved image surface 91 corresponds to the distance $L_{opt}$ from the apparatus 1 at which the paths of photons 17 that are incident on adjacent photodetectors 11 intersect. As, in the example of Fig. 9 any source of scattered of omnidirectional photons 17 located beyond $L_{opt}$ could have photons 17 detected by more than one photodetector 11 so this reduces the resolution for images positioned beyond $L_{opt}$.

In examples where the substrate 3 is curved, the thickness $d_{subs}$ of the substrate 3, the diameter $d_{via}$ of the apertures 5, the pixel pitch $d_{pix}$ and the radius of curvature $R_{bend}$ of the substrate 3 can all be selected to adjust the value of $L_{opt}$.

As $L_{opt}$ increases this introduces areas 93 on the curved image surface 91 where no photons 17 are emitted in alignment with the apertures 5. This means that no photons 17 from these areas 93 will be detected by the apparatus 1. This means that portions of the field of view will be missing from the detected image.

In the example arrangement of Fig. 10 the angle $\theta$ between two adjacent photodetectors 11 is given by

$$\theta = \frac{d_{pix}}{R_{bend}}$$

The curved image surface 91 at a distance $L_{opt}$ which provides a non-overlapping field of view for each photodetector 11 satisfies:

$$\alpha_{view} \cdot \left( L_{opt} + \frac{d_{subs}}{2} \right) = \theta \cdot \left( R_{bend} + d_{subs} + L_{opt} \right).$$

This can be re-written as

$$L_{opt} = \frac{d_{subs}\left( \theta - \frac{\alpha_{view}}{2} \right) + \theta \cdot R_{bend}}{\left( \alpha_{view} - \theta \right)} = \frac{d_{subs}\left( \frac{d_{pix}}{R_{bend}} - \frac{\alpha_{view}}{2} \right) + d_{pix}}{\left( \alpha_{view} - \frac{d_{pix}}{R_{bend}} \right)}.$$

By approximating

$$\alpha_{view} \approx 2 \cdot \frac{d_{via}}{d_{subs}},$$

$L_{opt}$ can be expressed as

$$L_{opt} = \frac{d_{subs}\frac{d_{pix}}{R_{bend}} + d_{via} + d_{pix}}{\left( 2\frac{d_{via}}{d_{subs}} - \frac{d_{pix}}{R_{bend}} \right)}.$$

From the above equation, it is evident that

$$L_{opt} \to \infty, \text{ when } \frac{R_{bend}}{d_{subs}} = \frac{1}{2}\frac{d_{pix}}{d_{via}}.$$

Therefore the optimal distance between the curved image surface 91 and the apparatus 1 can be selected by choosing appropriate dimensions for the thickness of the substrate 3 and the diameter of the apertures 5 and the radius of curvature of the substrate 3. This may enable the apparatus 1 to be optimized for a particular application.

The distance that is selected for $L_{opt}$ may depend on the application that the apparatus 1 is being used for. Some example figures for various cases are listed below:

(i) $L_{opt} \to \infty$ with $d_{pix}$=200$\mu$m, $d_{via}$=30$\mu$m, $d_{subs}$=300$\mu$m, $R_{bend}$=1mm. With these dimensions, a full circle of $2\pi R_{bend}$ would comprise 31 pixels.

(ii) $L_{opt} \to \infty$ with $d_{pix}$=400$\mu$m, $d_{via}$=30$\mu$m, $d_{subs}$=375$\mu$m, $R_{bend}$=2.5mm. With these dimensions, the full circle of $2\pi R_{bend}$ would comprise 39 pixels.

(iii) $L_{opt} \to \infty$ with $d_{pix}$=1mm, $d_{via}$=100$\mu$m, $d_{subs}$=20mm, $R_{ben}$ =10cm.

It is to be appreciated that the listed examples are for illustrative purpose and that other values could be used in other examples of the disclosure.

These different examples could be used for different applications. For instance, if the values of example (ii) were used, the apparatus 1 would be suitable for use as a pill type camera. The pill type camera would be small enough to be swallowed by a patient without discomfort. In such cases the camera may comprise a light source to enable internal images of the patient to be obtained. In such cases the apparatus 1 may be arranged to enable three dimensional images to be obtained.

The values of example (iii) may be used to provide a spherical camera. In such examples a spherical substrate 3 may be moulded with the graphene 13 photodetectors 11 on the inner surface of the sphere. The apertures 5 could then be drilled into the surface of the sphere. With the values of example (iii) such an apparatus would comprise 628 photodetectors 11 around the surface of the sphere.

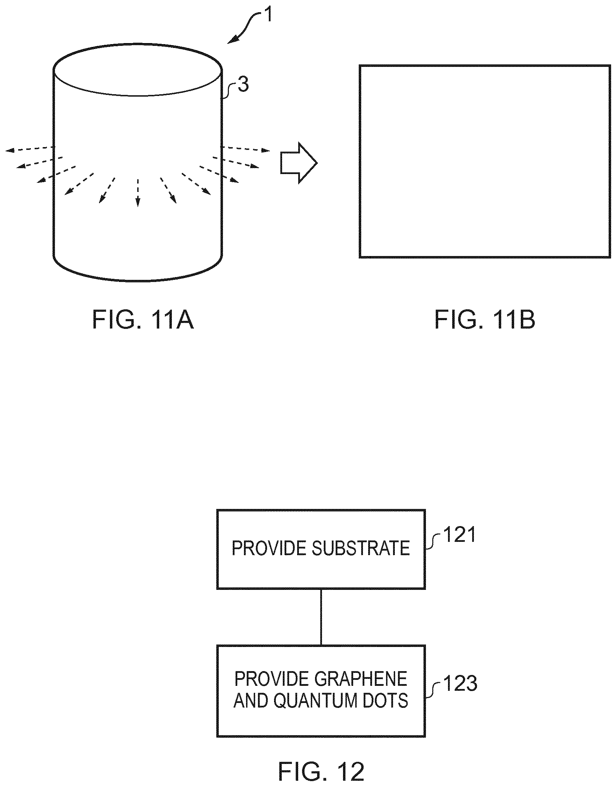

Figs. 11A and 11B illustrate an example apparatus 1 with a curved substrate.

Fig. 11A schematically illustrates an apparatus 1 where the substrate 3 is provided in a cylindrical shape. This may enable the apparatus 1 to be used to detect photons arriving from any direction to provide a full 360° field of view. The cylindrical shape may be formed by rolling a flat substrate 3 into a cylinder. In other examples the substrate 3 may be formed in a cylindrical arrangement.

Fig. 11B illustrates the projection of the image obtained by the three dimensional camera into a two dimensional format. Once the image has been converted into a two dimensional format it may be displayed on a display.

Fig. 12 illustrates an example method which may be used to form example apparatus 1 such as those described above.

The method comprises, at block 121 providing a substrate 3 comprising at least one aperture 5 extending through the substrate 3 wherein the aperture 5 has a first end 7 and a second end 9 and wherein the substrate 3 is arranged such that one or more photons 17 incident on the first end 7 of the aperture 5 pass through the aperture 5 to the second end 9. The method also comprises, at block 123, positioning graphene 13 functionalised with quantum dots 15 over the second end 9 of the aperture 5 to form a photodetector 11.

Examples of the disclosure provide an improved photodetector 11 that may be used as an imaging device.

In some examples the apparatus 1 may be provided within a lensless camera. As the camera is lensless this reduces the number of components in the apparatus 1. The field of view of the camera may be adjusted by adjusting the radius of curvature of the substrate 3.

In examples of the disclosure the pixel size is determined by the size of the photodetectors 11. The arrangements of the apparatus 1 in examples of the disclosure may enable larger pixel sizes and pixel pitches to be used in current CMOS (Complementary metal-oxide semiconductor) detectors which would be used in cameras with a lens system. This may enable lower cost technologies such as flexible printed circuit boards and quantum dot-graphene field effect transistor panels to be used.

In examples of the disclosure the graphene 13 may be suspended over the second end 9 of the aperture 5. As the graphene 13 is suspended this may reduce any defects or discontinuities that could be introduced into the graphene. This could improve the quality of the graphene channel and reduce noise in the signals obtained by the photodetectors 11.

The use of graphene 13 also provides the advantage that it is flexible and suitable for use in flexible circuits. This makes the quantum dot-graphene field effect transistor suitable for use in flexible and curved apparatus 1.

The quantum dot-graphene field effect transistors are also very sensitive photodetectors 11 and may enable images to be provided even for low levels of incident photons 17.

The use of the apertures 5 within the substrate 3 allows photons 17 that are not aligned with the apertures 5 to be filtered out. This makes the apparatus 1 suitable for use with an x-ray scintillator and enables high spatial resolution to be obtained without the need for a columnar scintillator.

The term "comprise" is used in this document with an inclusive not an exclusive meaning. That is any reference to X comprising Y indicates that X may comprise only one Y or may comprise more than one Y. If it is intended to use "comprise" with an exclusive meaning then it will be made clear in the context by referring to "comprising only one..." or by using "consisting".

In this brief description, reference has been made to various examples. The description of features or functions in relation to an example indicates that those features or functions are present in that example. The use of the term "example" or "for example" or "may" in the text denotes, whether explicitly stated or not, that such features or functions are present in at least the described example, whether described as an example or not, and that they can be, but are not necessarily, present in some of or all other examples. Thus "example", "for example" or "may" refers to a particular instance in a class of examples. A property of the instance can be a property of only that instance or a property of the class or a property of a subclass of the class that includes some but not all of the instances in the class. It is therefore implicitly disclosed that a features described with reference to one example but not with reference to another example, can where possible be used in that other example but does not necessarily have to be used in that other example.

**Claims**

1. An apparatus (1) comprising:

   a flat substrate (3) comprising a first surface, a second surface and a plurality of apertures (5) extending through the substrate (3) from the first surface to the second surface wherein the plurality of apertures (5) respectively have a first end (7) and a second end (9) and wherein the substrate (3) is arranged such that one or more photons (17) incident on the first end (7) of a respective aperture (5) pass through the respective aperture (5) to the second end (9); and

a plurality of photodetectors (11) positioned such that a photodetector is overlaying the second end (9) of each of the plurality of apertures (5) wherein the plurality of photodetectors (11) comprises graphene (13) functionalised with quantum dots (15) and wherein the plurality of apertures (5) extend perpendicular to a plane of the second surface and a plane of the plurality of photodetectors (11) and each of the plurality of apertures (5) are parallel to each other.

2. An apparatus (1) as claimed in any preceding claim wherein the graphene (13) of the photodetectors (11) is suspended over the second end (9) of the apertures (5).

3. An apparatus (1) as claimed in any preceding claim wherein the substrate (3) is arranged to absorb photons (17) so that photons (17) incident on an inner wall of an aperture (5) are absorbed.

4. An apparatus (1) as claimed in any preceding claim wherein the graphene (13) overlaying the second end of the aperture (5) is arranged as a channel within a field effect transistor.

5. An apparatus (1) as claimed in claim 4 wherein contact electrodes of the field effect transistor are formed on the substrate (3) adjacent to the second end (9) of the aperture (5).

6. An apparatus (1) as claimed in any preceding claim wherein the substrate (3) is flexible so as to enable a user to bend the substrate (3).

7. An apparatus (1) as claimed in any preceding claim wherein at least one aperture (5) is filled.

8. An apparatus (1) as claimed in any of claims 1 to 6 wherein at least one aperture (5) is non-filled.

9. An apparatus (1) as claimed in claim 8 comprising a support layer arranged to support the graphene (13) over the second end (9) of the aperture (5).

10. An apparatus (1) as claimed in claim 9 wherein the support layer comprises hexagonal boron nitride.

11. An apparatus (1) as claimed in any preceding claim wherein the diameter of the aperture (5) is smaller than the length of the aperture (5).

12. An apparatus (1) as claimed in any preceding claim comprising a scintillator overlaying the substrate (3) and arranged to convert incident x-rays into visible photons.

13. An x-ray detector comprising an apparatus (1) as claimed in any preceding claim.

14. A camera comprising an apparatus (1) as claimed in any of claims 1 to 12.

15. A method comprising:

providing a flat substrate (3) comprising a first surface, a second surface and a plurality of apertures (5) extending through the substrate (3) from the first surface to the second surface, wherein the plurality of apertures (5) have a first end (7) and a second end (9) and wherein the substrate (3) is arranged such that one or more photons (17) incident on the first end (7) of the aperture (5) pass through the aperture (5) to the second end (9); and positioning graphene (13) functionalised with quantum dots (15) over the second end of the plurality of apertures (5) to form a plurality of photodetectors such that a photodetector is positioned overlaying each of the apertures, wherein the plurality of apertures (5) extend perpendicular to a plane of the second surface and a plane of the plurality of photodetectors (11) and each of the plurality of apertures (5) are parallel to each other.

**Patentansprüche**

1. Vorrichtung (1), umfassend:

   ein flaches Substrat (3) mit einer ersten Oberfläche, einer zweiten Oberfläche und einer Vielzahl von Öffnungen (5), die sich durch das Substrat (3) von der ersten Oberfläche zu der zweiten Oberfläche erstrecken, wobei die Vielzahl von Öffnungen (5) jeweils ein erstes Ende (7) und ein zweites Ende (9) aufweisen und wobei das Substrat (3) so angeordnet ist, dass ein oder mehrere Photonen (17), die auf das erste Ende (7) einer jeweiligen Öffnung (5) einfallen, durch die jeweilige Öffnung (5) zu dem zweiten Ende (9) hindurchgehen; und
   eine Vielzahl von Fotodetektoren (11), die so positioniert sind, dass ein Fotodetektor über dem zweiten Ende (9) jeder der Vielzahl von Öffnungen (5) liegt, wobei die Vielzahl von Fotodetektoren (11) Graphen (13) umfasst, das mit Quantenpunkten (15) funktionalisiert ist, und wobei die Vielzahl von Öffnungen (5) sich senkrecht zu einer Ebene der zweiten Oberfläche erstreckt und eine Ebene der Vielzahl von Fotodetektoren (11) und jede der Vielzahl von Öffnungen (5) parallel zueinander sind.

2. Vorrichtung (1) nach einem der vorstehenden Ansprüche, wobei das Graphen (13) der Fotodetektoren (11) über dem zweiten Ende (9) der Öffnungen (5) aufgehängt ist.

3. Vorrichtung (1) nach einem der vorstehenden Ansprüche, wobei das Substrat (3) so angeordnet ist, dass es Photonen (17) absorbiert, so dass Photonen (17), die auf eine Innenwand einer Öffnung (5) einfallen, absorbiert werden.

4. Vorrichtung (1) nach einem der vorstehenden Ansprüche, wobei das Graphen (13), das das zweite Ende der Öffnung (5) überlagert, als ein Kanal innerhalb eines Feldeffekttransistors angeordnet ist.

5. Vorrichtung (1) nach Anspruch 4, wobei Kontaktelektroden des Feldeffekttransistors auf dem Substrat (3) neben dem zweiten Ende (9) der Öffnung (5) ausgebildet sind.

6. Vorrichtung (1) nach einem der vorstehenden Ansprüche, wobei das Substrat (3) flexibel ist, so dass ein Benutzer das Substrat (3) biegen kann.

7. Vorrichtung (1) nach einem der vorstehenden Ansprüche, wobei mindestens eine Öffnung (5) gefüllt ist.

8. Vorrichtung (1) nach einem der Ansprüche 1 bis 6, wobei mindestens eine Öffnung (5) nicht gefüllt ist.

9. Vorrichtung (1) nach Anspruch 8, umfassend eine Trägerschicht, die so angeordnet ist, dass sie das Graphen (13) über dem zweiten Ende (9) der Öffnung (5) trägt.

10. Vorrichtung (1) nach Anspruch 9, wobei die Trägerschicht hexagonales Bornitrid umfasst.

11. Vorrichtung (1) nach einem der vorstehenden Ansprüche, wobei der Durchmesser der Öffnung (5) kleiner ist als die Länge der Öffnung (5).

12. Vorrichtung (1) nach einem der vorstehenden Ansprüche, umfassend einen Szintillator, der das Substrat (3) überlagert und so angeordnet ist, dass er einfallende Röntgenstrahlen in sichtbare Photonen umwandelt.

13. Röntgendetektor umfassend eine Vorrichtung (1) nach einem der vorstehenden Ansprüche.

14. Kamera umfassend eine Vorrichtung (1) nach einem der Ansprüche 1 bis 12.

15. Verfahren umfassend:

   Bereitstellen eines flachen Substrats (3) mit einer ersten Oberfläche, einer zweiten Oberfläche und einer Vielzahl von Öffnungen (5), die sich durch das Substrat (3) von der ersten Oberfläche zu der zweiten Oberfläche erstrecken, wobei die Vielzahl von Öffnungen (5) jeweils ein erstes Ende (7) und ein zweites Ende (9) aufweisen und wobei das Substrat (3) so angeordnet ist, dass ein oder mehrere Photonen (17), die auf das erste Ende (7) der Öffnung (5) einfallen, durch die jeweilige Öffnung (5) zu dem zweiten Ende (9) hindurchgehen; und
   Positionieren von Graphen (13), das mit Quantenpunkten (15) funktionalisiert ist, über dem zweiten Ende der Vielzahl von Öffnungen (5), um eine Vielzahl von Fotodetektoren zu bilden, so dass ein Fotodetektor über jeder der Vielzahl von Öffnungen liegend positioniert wird, wobei die Vielzahl von Öffnungen (5) sich senkrecht zu einer Ebene der zweiten Oberfläche erstreckt und eine Ebene der Vielzahl von Fotodetektoren (11) und jede der Vielzahl von Öffnungen (5) parallel zueinander sind.

## Revendications

1. Appareil (1) comprenant :

   un substrat plat (3) comprenant une première surface, une deuxième surface et une pluralité d'ouvertures (5) s'étendant à travers le substrat (3) de la première surface à la deuxième surface, dans lequel la pluralité d'ouvertures (5) ont respectivement une première extrémité (7) et une deuxième extrémité (9), et dans lequel le substrat (3) est disposé de façon qu'un ou plusieurs photons (17) incidents sur la première extrémité (7) d'une ouverture respective (5) traversent l'ouverture respective (5) jusqu'à la deuxième extrémité (9) ; et
   une pluralité de photodétecteurs (11) positionnés de façon qu'un photodétecteur recouvre la deuxième extrémité (9) de chacune parmi la pluralité d'ouvertures (5), dans lequel la pluralité de photodétecteurs (11) comprend du graphène (13) fonctionnalisé avec des points quantiques (15), et dans lequel la pluralité d'ouvertures (5) s'étendent perpendiculairement à un plan de la deuxième surface et à un plan de la pluralité de photodétecteurs (11), et chacune parmi la pluralité d'ouvertures (5) est parallèle aux autres.

2. Appareil (1) selon l'une quelconque des revendications précédentes, dans lequel le graphène (13) des photodétecteurs (11) est suspendu au-dessus de la deuxième extrémité (9) des ouvertures (5).

3. Appareil (1) selon l'une quelconque des revendications précédentes, dans lequel le substrat (3) est disposé de manière à absorber des photons (17) de façon que des photons (17) incidents sur une paroi intérieure d'une ouverture (5) soient absorbés.

4. Appareil (1) selon l'une quelconque des revendications précédentes, dans lequel le graphène (13) recouvrant la deuxième extrémité de l'ouverture (5) est disposé sous la forme d'un canal à l'intérieur d'un transistor à effet de champ.

5. Appareil (1) selon la revendication 4, dans lequel des électrodes de contact du transistor à effet de champ sont formées sur le substrat (3) adjacent à la deuxième extrémité (9) de l'ouverture (5).

6. Appareil (1) selon l'une quelconque des revendications précédentes, dans lequel le substrat (3) est flexible de façon à permettre à un utilisateur de plier le substrat (3).

7. Appareil (1) selon l'une quelconque des revendications précédentes, dans lequel au moins une ouverture (5) est remplie.

8. Appareil (1) selon l'une quelconque des revendications 1 à 6, dans lequel au moins une ouverture (5) n'est pas remplie.

9. Appareil (1) selon la revendication 8, comprenant une couche de support disposée de manière à supporter le graphène (13) au-dessus de la deuxième extrémité (9) de l'ouverture (5).

10. Appareil (1) selon la revendication 9, dans lequel la couche de support comprend du nitrure de bore hexagonal.

11. Appareil (1) selon l'une quelconque des revendications précédentes, dans lequel le diamètre de l'ouverture (5) est inférieur à la longueur de l'ouverture (5).

12. Appareil (1) selon l'une quelconque des revendications précédentes, comprenant un scintillateur recouvrant le substrat (3) et disposé de manière à convertir des rayons X incidents en photons visibles.

13. Détecteur de rayons X comprenant un appareil (1) selon l'une quelconque des revendications précédentes.

14. Caméra comprenant un appareil (1) selon l'une quelconque des revendications 1 à 12.

15. Procédé comprenant :

l'obtention d'un substrat plat (3) comprenant une première surface, une deuxième surface et une pluralité d'ouvertures (5) s'étendant à travers le substrat (3) de la première surface à la deuxième surface, dans lequel la pluralité d'ouvertures (5) ont une première extrémité (7) et une deuxième extrémité (9), et dans lequel le substrat (3) est disposé de façon qu'un ou plusieurs photons (17) incidents sur la première extrémité (7) de l'ouverture (5) traversent l'ouverture (5) jusqu'à la deuxième extrémité (9) ; et

le positionnement de graphène (13) fonctionnalisé avec des points quantiques (15) au-dessus de la deuxième extrémité de la pluralité d'ouvertures (5) pour former une pluralité de photodétecteurs de façon qu'un photodétecteur soit positionné en recouvrant chacune des ouvertures,

dans lequel la pluralité d'ouvertures (5) s'étendent perpendiculairement à un plan de la deuxième surface et à un plan de la pluralité de photodétecteurs (11), et chacune parmi la pluralité d'ouvertures (5) est parallèle aux autres.

FIG. 1

FIG. 2A

FIG. 2C

FIG. 2B

FIG. 2D

FIG. 3A

FIG. 3B

FIG. 4

FIG. 5

FIG. 6

FIG. 7

FIG. 8

FIG. 9

FIG. 10

FIG. 11A

FIG. 11B

PROVIDE SUBSTRATE — 121

PROVIDE GRAPHENE AND QUANTUM DOTS — 123

FIG. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060244907 A
- US 2014263945 A